**Europäisches Patentamt**

**European Patent Office**

**Office européen des brevets**

(19)

(11) Numéro de publication: **0 115 234**
**B1**

(12)

# FASCICULE DE BREVET EUROPÉEN

(45) Date de publication du fascicule du brevet:
18.03.87

(21) Numéro de dépôt: 83402485.3

(22) Date de dépôt: 20.12.83

(51) Int. Cl.⁴: **H 04 N 9/455**, H 03 L 7/10

(54) Procédé et circuit d'asservissement en fréquence et en phase d'un oscillateur local en télévision.

(30) Priorité: 23.12.82 FR 8221624

(43) Date de publication de la demande:
08.08.84 Bulletin 84/32

(45) Mention de la délivrance du brevet:
18.03.87 Bulletin 87/12

(84) Etats contractants désignés:
DE FR GB IT NL

(56) Documents cité:
GB-A-2 008 347
US-A-4 151 485

(73) Titulaire: THOMSON- CSF, 173, Boulevard
Haussmann, F-75379 Paris Cedex 08 (FR)

(72) Inventeur: Douziech, Patrick, THOMSON- CSF
SCPI 173, bld Haussmann, F-75379 Paris Cedex 08
(FR)
Inventeur: Imbert, Michel, THOMSON- CSF SCPI
173, bld Haussmann, F-75379 Paris Cedex 08 (FR)

(74) Mandataire: Ruellan- Lemonnier, Brigitte,
THOMSON- CSF SCPI 19, avenue de Messine,
F-75008 Paris (FR)

EP 0 115 234 B1

## Description

La presente invention concerne le domaine des circuits de télévision couleurs et, plus particulièrement, les circuits de décodage de chrominance. Elle s'applique notamment à la réception d'émissions télévisées transmises selon les normes PAL ou NTSC.

Dans ces systèmes d'émission et de réception de télévision, il est nécessaire, pour extraire les informations de chrominance qui se trouvent être modulées en amplitude et en phase sur une sousporteuse de fréquence déterminée, de produire à l'intérieur du récepteur un signal de même fréquence et présentant une relation de phase déterminée avec les signaux émis.

De façon classique, pour atteindre ce resultat, on utilise un oscillateur local ayant une fréquence aussi proche que possible de la fréquence émise, c'est-à-dire selon les standards usuels 4,43 MHz dans le système PAL et 3,58 MHz dans le système NTSC, et on asservit cet oscillateur en frequence et en phase sur un signal émis, a savoir le signal de salve. On rappellera la structure des signaux d'une ligne de télévision couleurs: ils comprennent successivement un signal d'effacement à bas niveau suivi de quelques alternances (une dizaine) d'un signal de salve, c'est-à-dire d'un signal alternatif à la fréquence de la sousporteuse de chrominance; on trouve ensuite les informations proprement dites de luminance et de chrominance correspondant à la ligne de télévision.

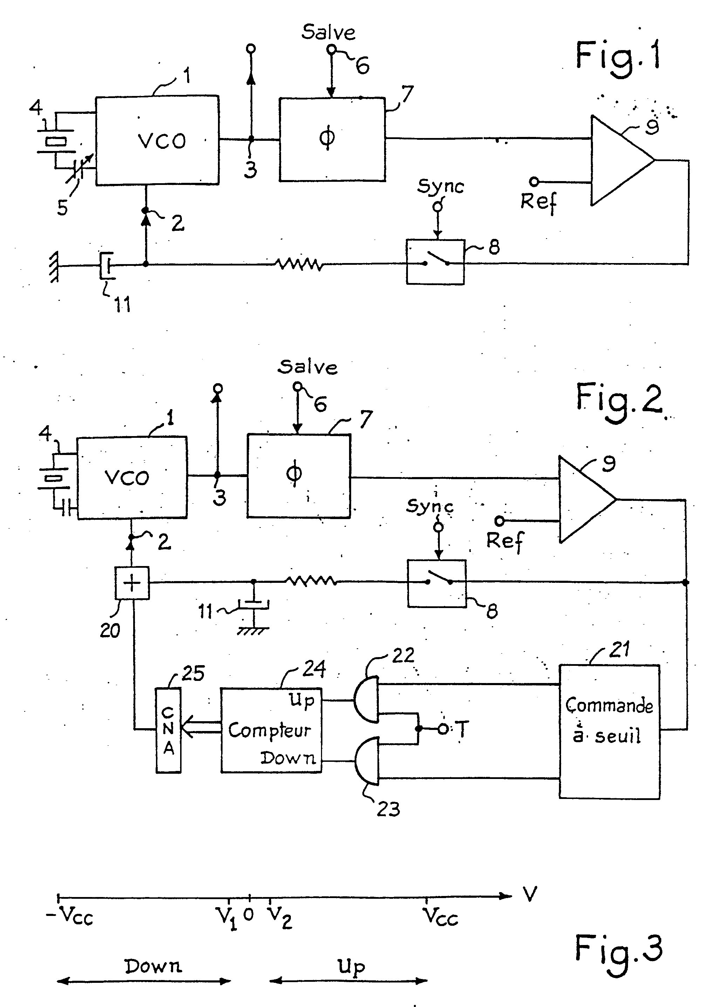

La figure 1 représente de façon très schématique un exemple de circuit classique d'oscillateur local associé à une boucle d'asservissement sur le signal de salve. Ce circuit comprend un oscillateur 1 muni d'une entrée de commande 2 agissant pour modifier la fréquence et la phase du signal de sortie 3. Ce type d'oscillateur est couramment désigné dans la technique par le sigle VCO des termes anglo-saxons Voltage Controlled Oscillator (oscillateur commandé en tension). Un quartz 4 permet d'obtenir une grande stabilité et un condensateur réglable 5 permet d'ajuster a la fabrication la frequence de l'oscillateur 1. Le signal de sortie 3 est comparé en phase au signal de salve 6 dans un comparateur de phase 7, pendant la durée de la salve. La sortie du comparateur 7 est connectée à la première entrée d'un amplificateur différentiel 9 dont l'autre entrée reçoit un signal de reference Ref. La sortie de l'amplificateur 9 est envoyée à l'entrée de commande 2 de l'oscillateur 1 par l'intermédiaire d'un interrupteur 8 fermé pendant la durée de la salve. Il faut en plus prévoir dans la boucle d'asservissement une certaine constante de temps, par exemple de l'ordre de grandeur d'une quinzaine de lignes, soit environ une milliseconde, nécessaire pour stocker l'information d'asservissement sur une ligne. Cette constante de temps est symbolisée dans la figure par un condensateur 11. En pratique, le circuit intégré comprend la plupart des éléments illustrés en figure 1, à l'exception toutefois du condensateur 11, du quartz 4 et de son condensateur de réglage 5.

Le type de circuit classique représenté en figure 1 présente plusieurs inconvénients. L'essentiel est qu'il exige un oscillateur 1 de très hautes précision et stabilité, c'est-à-dire en fait un oscillateur à quartz muni d'un moyen de réglage de la fréquence de repos (condensateur réglable 5). Ceci est dû au fait que le système de boucle analogique d'asservissement a nécessairement un gain faible pour des raisons de stabilité. Cette nécessité de prévoir un oscillateur dont la fréquence de repos est aussi proche que possible de la fréquence recherchée oblige à effectuer un réglage à la fabrication, ce qui est un facteur de coût non négligeable.

A titre d'exemple, pour un circuit de television commercial classique, le comparateur de phase et son amplificateur associé fournissent une tension de 10 mV pour une erreur de phase de 1° et la fréquence de l'oscillateur varie de 2 Hz par mV, c'est-à-dire que le gain de boucle est de 20 Hz/°. L'erreur de phase tolérable etant de + ou - 0,5°, avec ce système on ne peut rattraper des erreurs de fréquence supérieures à 10 Hz, ce qui explique la nécessité d'un oscillateur à quartz avec un condensateur de réglage.

Dans le cas où l'on veut rattraper les erreurs de fréquences d'un oscillateur à quartz sans reglage, qui peuvent être de l'ordre de 300 Hz tout en gardant une erreur de phase non supérieure à 0,5°, il faudrait un gain de boucle de 600 Hz/°. On va montrer que dans ce cas la boucle ne peut plus être stable. En effet, s'il existe à un instant t un déphasage y entre les deux entrées 3 et 6 du comparateur de phase 7, lors du debut de la comparaison entre la sortie de l'oscillateur et la salve, ce déphasage va modifier la fréquence f de l'oscillateur d'une quantité:

$$df = 600 \, y.$$

Pendant la durée $T = 2,2 \, \mu s$ de la salve, il en résulte un déphasage dy tel que:

$$dy = df \times 360 \times T$$

soit $dy = 600 \, y \times 360 \times 2,2 \, 10^6 \cong 0,5 \, y$.

Le déphasage en fin de comparaison de la salve sera alors approximativement de $y - 0,5 \, y = 0,5 \, y$. La tension en sortie du comparateur de phase est alors mémorisée en fin de comparaison et la variation de frequence df jusqu'à la prochaine salve est:

$$df = 0,5 \, y \times 600 = 300 \, y,$$

ce qui introduit 62 μS plus tard (durée d'une ligne) un déphasage dy égal à:

$$dy = df \times 360 \times 62 \, 10^{-6} = 300 \, y \times 360 \times 62 \, 10^{-6} = 6,7 \, y.$$

Ce déphasage est opposé au déphasage précédent de 0,5 y.

Le déphasage initial y est donc converti en déphasage 6,2 y qui sera lui-même converti en 38 y, etc... Le système diverge donc en raison de la trop forte valeur du gain de boucle.

Un objet de la présente invention est de prévoir un oscillateur local asservi en frequence et en phase évitant les inconvénients cités précédemment des systèmes classiques. Essentiellement, la présente invention vise à permettre d'utiliser un oscillateur à quartz, sans qu'il soit nécessaire de prévoir un réglage de la fréquence de repos.

Pour atteindre cet objet ainsi que d'autres, la présente invention prevoit un procédé d'asservissement en fréquence et en phase sur la salve d'un signal de télévision couleurs d'un oscillateur muni d'une entrée de commande de fréquence et de phase consistant à: comparer en phase le signal de sortie de l'oscillateur et la salve pendant la durée de celle-ci; produire un signal d'erreur utilisé pour agir sur l'entrée de commande de l'oscillateur; vérifier si ce signal d'erreur se trouve en dehors ou a l'intérieur d'une plages déterminée; si le signal d'erreur se trouve en dehors de cette plage, agir sur un compteur-décompteur dont la sortie, transformée en signal analogique, est aussi appliquée à l'entrée de commande de l'oscillateur de façon à ramener le signal d'erreur à l'intérieur de la plage prédéterminée. De préférence, l'action d'un pas du compteur-décompteur transformée en signal analogique, au voisinage de la plage prédéterminée, est propre à ramener les signaux d'erreur d'une extrémité de cette plage sensiblement vers le centre de celle-ci.

Un circuit d'asservissement en fréquence et en phase sur la phase d'un signal de télévision couleurs d'un oscillateur muni d'une entrée de commande de fréquence et de phase selon la présente invention comprend: un oscillateur intégré; un comparateur de phase comparant la sortie de l'oscillateur à un signal de salve; un amplificateur différentiel comparant la sortie du comparateur de phase à un signal de référence; une boucle d'asservissement classique appliquant la sortie de l'amplificateur à l'entrée de commande de l'oscillateur; un circuit de commande à seuil; un compteur-décompteur incrémenté ou décrémenté selon la valeur de la sortie de l'amplificateur par rapport à une plage de tension déterminée du circuit de commande à seuil; et un convertisseur numérique-analogique recevant la sortie du compteur et l'envoyant à l'entrée de commande de l'oscillateur avec la sortie de la boucle d'asservissement classique.

Ces objets, caractéristiques et avantages ainsi que d'autres de la présente invention seront exposés plus en détail dans la description suivante d'un mode de réalisation particulier faite en relation avec les figures jointes parmi lesquelles:

- la figure 1, décrite précédemment, représente un oscillateur local associé à une boucle analogique d'asservissement en phase selon un schéma classique;

- la figure 2 représente un oscillateur local associé à une boucle d'asservissement selon la présente invention;

- la figure 3 illustre diverses plages de tension dans lesquelles fonctionne un dispositif de commande à seuil faisant partie du circuit de la figure 2.

En figure 2, on a repris autant que faire se pouvait des références identiques pour désigner des blocs ou éléments analogues à ceux de la figure 1.

Le circuit selon la présente invention, illustré en figure 2, comprend tout d'abord un circuit tel que représenté en figure 1 à boucle d'asservissement classique, mais dans lequel l'oscillateur local 1 est associé à un quartz 4, mais plus à un condensateur 5 réglable, c'est-à-dire que la fréquence de repos de cet oscillateur n'est pas ajustée à la fabrication. Ainsi, la boucle classique n'a pas, comme cela a été exposé ci-dessus, un gain suffisant pour des raisons de stabilité, pour lui permettre d'assurer un écart de phase faible par rapport à la phase de la salve. Pour pallier cet inconvénient et pour permettre d'utiliser uun oscillateur local 1 non préréglé à la fréquence souhaitée, ou à une valeur très proche de celle-ci, la présente invention ajoute par un sommateur 20 à l'action de la boucle classique décrite précédemment l'action d'une boucle analogique-numérique-analogique qui sera décrite ci-après.

La sortie de l'amplificateur différentiel 9 est envoyée à l'entrée d'un circuit de commande à seuil 21. En fonction du niveau de cette entrée, comme on le verra ci-après, ce circuit de commande à seuil fournit une sortie vers l'une ou l'autre de deux portes ET 22 et 23 dont la sortie est reliée aux entrées de comptage (Up) et de décomptage (Down) d'un compteur-décompteur 24. La sortie numérique de ce compteur est transmise par l'intermédiaire d'un convertisseur numerique-analogique 25 à la borne de commande 2 de l'oscillateur 1, par l'intermediaire du sommateur 20.

Comme le montre la figure 3, le circuit de commande à seuil 21 fournit des sorties distinctes selon que son signal d'entrée se trouve dans l'une ou l'autre de trois plages partageant la tension de sortie de l'amplificateur 9 qui peut être comprise entre un minimum (-Vcc) et un maximum (Vcc). La première plage, comprise entre -Vcc et une tension V1, sera appelée "plage inférieure". La plage comprise entre les tensions V1 et V2 sera appelée "plage prédéterminée". La dernière plage comprise entre des tensions V2 et Vcc est appelée "plage supérieure".

La boucle classique comprenant le filtre constitué de la résistance et du condensateur 11 a par exemple une constante de temps de l'ordre d'une quinzaine de lignes de télévision. On choisira pour le circuit analogique-numérique-analogique additionnel une "constante de temps" bien supérieure, par exemple de l'ordre d'une trame de télévision, c'est-à-dire que la deuxième entrée des portes ET 22 et 23 recevra un signal T constitué d'une impulsion pour chaque trame.

Pour expliquer le fonctionnement du dispositif selon l'invention, supposons d'abord que la boucle classique fonctionne seule. En ce cas, une tension d'erreur importante aura tendance à apparaître à la sortie de l'amplificateur 9. Cette tension d'erreur se trouvera en dehors de la plage prédéterminée V1-V2 du circuit de commande à seuil 21. Celui-ci incrémentera à chaque trame de télévision le compteur dans le sens croissant ou décroissant selon le cas pour fournir un signal correcteur à l'additionneur 20. Le signal d'erreur à la sortie de l'amplificateur 9 sera donc progressivement réduit jusqu'à ce qu'il arrive à l'intérieur de la plage V1-V2. Ainsi, la boucle classique n'aura en définitive qu'à corriger une erreur relativement faible, l'erreur de grande amplitude étant rattrapée par la boucle numérique. On pourra en conséquence améliorer considérablement la précision du système. En supposant que l'action sur l'entrée de commande soit linéaire, et que le compteur comprenne n étages, n étant un nombre entier, on divise par $2^n$ l'efficacité nécessaire de la boucle classique: c'est-à-dire qu'avec une boucle classique de gain donné on augmentera d'un facteur $2^n$ la précision de la mise en phase.

De préférence, le pas d'incrémentation du compteur est choisi pour que, dès que la tension d'erreur atteint la valeur V1 ou V2, une incrémentation du compteur ramène la tension d'erreur sensiblement au centre de la plage V1-V2. Parmi les avantages de la boucle analogique-numérique-analogique additionnelle selon la présente invention, on notera qu'elle est constituée d'éléments complètement intégrables étant donné notamment qu'elle permet de maintenir une tension de correction à sa sortie sans comprendre de condensateur de forte valeur.

On peut aussi rajouter au circuit de commande à seuil 21 une entree correspondant à la sortie du circuit portier. Ce circuit, existant dans tout téléviseur, fournit un signal bas notamment quand l'asservissement de l'oscillateur 1 n'est pas adéquat. Cette entrée agit par exemple sur l'entrée Up du compteur 24. Si la fréquence de la salve est en dehors de la plage de capture de l'oscillateur, le comparateur 7 donne une tension de sortie à valeur moyenne nulle (battement) qui filtrée, par le condensateur 11, maintient l'entrée 2 nulle. De plus, la tension sur le condensateur 11 étant nulle, les commandes Up et Down sont inactives et le système n'evolue pas, il n'y a pas d'asservissement.

Si par contre, par l'intermédiaire de l'information de portier (qui est basse en non asservi et haute en asservi), on active l'entrée Up du compteur, le système peut évoluer par comptage puis variation de l'entree 2 et ainsi déplacer sa plage de capture jusqu'à ce qu'elle englobe la fréquence de la salve. La nouvelle plage de capture du système est ainsi encore augmentée.

### Revendications

1. Procédé d'asservissement en fréquence et en phase, sur la salve d'un signal de television couleur, d'un oscillateur muni d'une entrée de commande de fréquence et de phase consistant à comparer en phase le signal de sortie de l'oscillateur et la salve pendant la durée de celle-ci et à produire un signal d'erreur utilisé pour agir sur ladite entrée de commande, caractérisé en ce qu'il consiste en outre à:
- vérifier si le signal d'erreur se trouve en dehors ou à l'intèrieur d'une plage déterminée (V1-V2),
- si le signal-d'erreur se trouve en dehors de ladite plage, agir sur un compteur-décompteur (24) dont la sortie, transformée en signal analogique, est aussi appliquée à ladite entrée de commande de façon à ramener le signal d'erreur à l'intérieur de ladite plage.

2. Procédé selon la revendication 1, caractérisé en ce que, au voisinage de ladite plage, l'action d'un pas du compteur-décompteur, transformée en signal analogique, est propre à ramener le signal d'erreur d'une extrémité de ladite plage sensiblement au centre de celle-ci.

3. Circuit d'asservissement en fréquence et en phase, sur la phase d'un signal de télévision couleur, d'un oscillateur muni d'une entrée de commande de fréquence et de phase comprenant un oscillateur (1), un comparateur de phase (7) comparant la sortie de l'oscillateur à un signal de salve (6), un amplificateur différentiel (9) comparant la sortie du comparateur de phase à un signal de référence, et une boucle d'asservissement classique appliquant la sortie de l'amplificateur à l'entrée de commande de l'oscillateur, caractérisé en ce qu'il comprend en outre:
- un circuit de commande à seuil (21),
- un compteur-décompteur (24) incrémenté ou décrémenté selon la valeur de la sortie de l'amplificateur (9) par rapport à une plage de tension déterminée du circuit de commande à seuil,
- un convertisseur numérique-analogique (25) recevant la sortie du compteur (24) et l'envoyant à l'entrée de commande (2) de l'oscillateur.

### Patentansprüche

1. Verfahren zum Nachregeln der Frequenz und Phase eines Oszillators durch die Impulssalve eines Farbfernsehsignals, wobei der Oszillator einen Frequenz- und Phasen-Steuereingang aufweist, darin bestehend, daß ein Phasenvergleich zwischen dem Ausgangssignal des Oszillators und der Impulssalve während der Dauer derselben vorgenommen wird und ein Fehlersignal erzeugt wird, das verwendet wird, um auf den genannten Steuereingang einzuwirken, dadurch gekennzeichnet, daß es ferner darin besteht, daß:
- überprüft wird, ob das Fehlersignal sich außerhalb oder innerhalb eines bestimmten Bereiches (V1-V2) befindet,
- wenn das Fehlersignal sich außerhalb dieses Bereiches befindet, auf einen Aufwärts/Abwärts-Zähler (24) eingewirkt wird, dessen in ein Analogsignal umgesetztes Ausgangssignal ebenfalls an den genannten Steuereingang angelegt wird, um das Fehlersignal in den genannten Bereich zurückzubringen.

2. Verfahren nach Anspruch 1, dadurch gekennzeichnet, daß in der Nähe des genannten Bereiches die Wirkung eines Schrittes des Aufwärts/Abwärts-Zählers nach Umsetzung in ein Analogsignal geeignet ist, um das Fehlersignal von einem Ende des genannten Bereiches angenähert in die Mitte desselben zu verlagern.

3. Schaltung zur Nachregelung der Frequenz und Phase eines Oszillators durch die Impulssalve eines Farbfernsehsignals, wobei der Oszillator einen Frequenz- und Phasen-Steuereingang aufweist, mit einem Oszillator (1), einem Phasenkomparator (7), welcher das Ausgangssignal des Oszillators mit einem Impulssalvensignal (6) vergleicht, einem Differenzverstärker (9), welcher das Ausgangssignal des Phasenkomparators mit einem Referenzsignal vergleicht, und mit einer herkömmlichen Regelschleife, welche das Ausgangssignal des Verstärkers mit dem Steuereingang des Oszillators verbindet, dadurch gekennzeichnet, daß sie ferner umfaßt:
  - eine Schwellwert-Steuerschaltung (21),
  - einen Aufwärts/Abwärts-Zähler (24), der je nach dem Wert des Ausgangssignals des Verstärkers (9) bezüglich eines bestimmten Spannungsbereiches der Schwellwert-Steuerschaltung inkrementiert oder dekrementiert wird,
  - einen Digital/Analog-Umsetzer (25), welcher das Ausgangssignal des Zählers (24) empfängt und zum Steuereingang (2) des Oszillators schickt.

**Claims**

1. Method of controlling the frequency and phase of an oscillator by the burst of a color television signal, the oscillator having a frequency and phase control input, consisting in comparing the phases of the output signal of the oscillator and the burst during the duration thereof and producing an error signal used for acting on said control input, characterized in that it further consists in:
  - verifying whether the error signal is outside of or within a determined range (V1-V2),
  - when the error signal is outside of said range, acting on an up/down counter (24) the output of which is transformed into an analog signal and likewise applied to said control input in a manner to relocate the error signal within said range.

2. Method according to claim 1, characterized in that, in the neighborhood of said range, the action of one step of the up/down counter, transformed into an analog signal, is appropriate to relocate the error signal from one end of said range substantially to the center thereof.

3. Circuit for controlling the frequency and phase of an oscillator by the phase of a color television signal, the oscillator having a frequency and phase control input, comprising an oscillator (1), a phase comparator (7) comparing the output of the oscillator with a burst signal (6), a differential amplifier (9) comparing the output of the phase comparator to a reference signal, and a conventional control loop connecting the output of the amplifier to the control input of the oscillator, characterized in that it further comprises:
  - a threshold control circuit (21),
  - an up/down counter (24) incremented or decremented according to the value of the output of the amplifier (9) with respect to a determined voltage range of the threshold control circuit,
  - a digital-analog converter (25) receiving the output of the counter (24) and transmitting it to the control input (2) of the oscillator.

0 115 234

Fig.1

Fig.2

Fig.3